# EUROPEAN PATENT APPLICATION

(11) **EP 4 300 576 A2**
(43) Date of publication of application: **03.01.2024**
(21) Application number: 23209817.8
(22) Date of filing: 22.12.2017
(51) Int. Cl.: H01L 23/538

(54) **METHOD OF MANUFACTURING A COMPONENT CARRIER**

(30) Priority: 30.12.2016 CN 201611258541
(62) Divisional of application: 17210055.4
(71) Applicant: At&S (China) Co., Ltd., Shanghai 201108 (CN)
(72) Inventor: TAY, Seok Kim (Annie), 128807 Singapore (SG); TUOMINEN, Mikael Andreas, 25500 Pernio (FI); BAFTIRI, Artan, Chongqing, 401121 (CN)
(74) Representative: Donatello, Daniele

(57) **Abstract**

A component carrier (106), comprising a stack (116) comprising at least one electrically conductive layer structure (114) and/or at least one electrically insulating layer structure (112), a sheet (100) with nano- and/or microstructures (102) and arranged on and/or in the stack (116), said sheet (100) comprising or consisting of copper.

## Description

The invention relates to a component carrier, to an arrangement, to a method of manufacturing a component carrier and to a method of use.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Moreover, proper adhesion between elements of a component carrier is an issue. Delamination between adjacent layers of a layer stack of a component carrier may deteriorate reliability of the component carrier. On the other hand, there are also other scenarios in which a repellent property of a constituent of a component carrier is desired, for instance a release layer for forming a cavity in a component carrier.

It is an object of the invention to provide a component carrier with high reliability and high flexibility in terms of its properties.

In order to achieve the object defined above, a component carrier, an arrangement, a method of manufacturing a component carrier and a method of use according to the independent claims are provided.

According to an exemplary embodiment of the invention, a method of using a sheet with nano- and/or microstructures on a sheet surface for manufacturing a component carrier is provided.

According to another exemplary embodiment of the invention, a component carrier is provided which comprises a stack comprising at least one electrically conductive layer structure and/or at least one electrically insulating layer structure, and a sheet with nano- and/or microstructures and arranged on and/or in the stack.

According to still another exemplary embodiment of the invention, an arrangement is provided which comprises a component carrier, comprising a stack which comprises at least one electrically conductive layer structure and/or at least one electrically insulating layer structure, wherein the arrangement further comprises a body, wherein at least one of the component carrier and the body comprises a sheet with nano- and/or microstructures configured as a dry adhesive for holding the component carrier and the further body on one another.

According to still another exemplary embodiment of the invention, a method of manufacturing a component carrier is provided, wherein the method comprises providing a stack comprising at least one electrically conductive layer structure and/or at least one electrically insulating layer structure, and connecting a sheet with nano- and/or microstructures with (in particular on and/or in) the stack.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "nano- and/or microstructures" may particularly denote physical structures with dimensions in the range of nanometers to micrometers, in particular having dimensions in a range between 0.1 nm and 10 µm, more particularly in a range between 1 nm and 500 nm. A sheet having a surface equipped with such nano- and/or microstructures, for instance in an ordered way (for example in rows and columns) or in a random way, may provide specific properties in terms of adhesion with adjacent component carrier material. Depending on the material, shape, dimension, coating and arrangement of the nano- and/or microstructures on the sheet surface, the nano- and/or microstructures may have an adhesive effect (such as at a leg of a gecko) or a repellent effect (such as on a surface of a lotus flower). A sheet may have at least 100, in particular at least 1000, nano- and/or microstructures. For instance, a sheet with nanostructures providing an adhesive property may be converted into a sheet with nanostructures providing a non-adhesive or even repellent property by a corresponding surface coating of the nano- and/or microstructures (for instance with a waxy material). For instance, the nano- and/or microstructures may be nano- and/or microprotrusions and/or nano- and/or microindentations.

According to an exemplary embodiment of the invention, a sheet with nano- and/or microstructures may be integrated in a component carrier such as a printed circuit board. By taking this measure, the specific adhesive properties of a sheet with nano- and/or microstructures may be advantageously used for simplifying manufacturing a component carrier and connection thereof with another body, a component to be surface-mounted thereon or embedded therein, etc. This allows to manufacture the component carrier with low effort and to connect or disconnect it selectively with another body. Due to the high flexibility of adjusting the adhesive properties (i.e. to be adhering or repellent) depending on the properties of the nano- and/or microstructures, a board designer has a high freedom of adjusting the interconnection properties within the component carrier and/or between the component carrier in relation to a further body. Highly advantageously, such a sheet with nano- and/or microstructures may be dry so that the implementation of liquids, chemicals, etc. for establishing adhering or repellent functions may become dispensable.

In the following, further exemplary embodiments of the component carrier, the arrangement, the method of manufacturing a component carrier and the method of use will be explained.

In an embodiment, the sheet is used as dry adhesive. Such dry adhesive may accomplish an adhesion, in a similar way as a glue, between the sheet and adjacent material of a component carrier or material of an adjacent body. The use of a liquid adhesive material or other chemicals in a non-solid state may therefore become dispensable. By a merely physical effect (in particular on the basis of van der Waals forces, or based on an interlocking between cooperating nano- and/or microstructures), adhesion can be accomplished.

In another embodiment, the sheet is used as repellent structure, in particular as a release layer. A repellent effect of nano- and/or microstructures may for example be accomplished by an appropriate coating of nano- and/or microstructures. According to such an embodiment, a position of a material separation on a surface of the component carrier or in an interior thereof can be precisely defined. This can be for instance advantageously when a specific surface of the component carrier shall not be connected to any other body or shall be kept free of dust. It may also be advantageous to implement such an embodiment to a scenario in which a cavity shall be formed in a component carrier. In such a scenario, a buried or embedded release layer having nano- and/or microstructures can define a position at which a portion of the component carrier can be easily separated for instance by laser cutting. Such a portion, defined by the repellent layer and a circumferential cutting line, may then be removed from the remainder of the component carrier due to the repellent function of the nano- and/or microstructures, so that a component carrier with cavity remains.

In an embodiment, the sheet is used for establishing an (in particular reversible) interlocking connection with a further sheet with further nano- and/or microstructures on a further sheet surface by interlocking between the nano- and/or microstructures and the further nano- and/or microstructures. Thus, two sheets with corresponding properties, both implementing nano- and/or microstructures of the same or different type, may be implemented in terms of component carrier technology in a similar way as a Velcro connection. By taking this measure, it may be possible that sheet and further sheet may be connected and may be disconnected by simply attaching or detaching them. In one embodiment, the nano- and/or microstructures of one sheet may be hooks, whereas the nano- and/or microstructures of the other sheet may be loops. It is however also possible that the nano- and/or microstructures of both cooperating sheets have hooks interlocking with one another in a reversible way.

In an embodiment, the sheet with nano- and/or microstructures is electrically conductive (in particular comprises or consists of copper or any other electrically conductive material compatible with component carrier technology, more particularly PCB technology). Therefore, the sheet with the nano- and/or microstructure may also contribute to the transport of electric signals and/or of electric power within the component carrier. It may establish an electric coupling merely by attaching it to another electrically conductive body and may therefore fulfil a plug/socket function.

In another embodiment, the sheet with nano- and/or microstructures is electrically insulating (in particular comprises or consists of resin, prepreg, at least partially uncured material, polymer material, ceramic material, glass, or any other electrically insulating material compatible with component carrier technology, more particularly PCB technology). Therefore, electrically insulating portions of a component carrier may be built using the sheet with nano- and/or microstructures. When made of an at least partially uncured material (such as prepreg), the sheet may establish a preliminary adhesion with another body by the nano- and/or microstructures, wherein the adhesion may be further strengthened by curing the at least partially uncured material which already forms part of the sheet.

In an embodiment, the nano- and/or microstructures are formed by exposing the sheet surface to a laser treatment. For instance, a laser may pattern a surface of a sheet to thereby generate the nano- and/or microstructures. It is however also possible that such a formation of nano- and/or microstructures is performed by a lithography and etching procedure. According to yet another exemplary embodiment, the nano- and/or microstructures may be immobilized on a surface of the sheet, for instance by forming, depositing or growing nanotubes or nanowires on a sheet surface.

In an embodiment, the sheet is interconnected with at least one electrically insulating layer structure and/or at least one electrically conductive layer structure, in particular by laminating. Highly advantageously, it is possible that the material of the sheet is configured so that it can be laminated with other structures. For instance, it may be made of at least partially uncured material such as resin being curable by the application of heat and/or pressure. After provisional connection between the sheet and another body or structure of a component carrier or an arrangement, permanent interconnection may then be accomplished by lamination during which the previously partially uncured material of the sheet with the nano- and/or microstructures cures.

In an embodiment, the sheet is interconnected with the stack due to a dry adhering configuration of the nano- and/or microstructures. This renders an interior of the component carrier robust so that an integral structure can be formed between the sheet with nano- and/or microstructures and other material of the stack. This also safely prevents undesired delamination and warpage, for instance under the influence of thermal load or thermal cycles occurring during operation of the component carrier. The nano- and/or microstructures may therefore improve reliability of the component carrier.

In an embodiment, the sheet is configured for being releasable from at least a part of the stack due to a repellent configuration of the nano- and/or microstructures. Such an embodiment may be advantageous in terms of release layers being embedded in an interior of the component carrier and defining a desired delamination position upon separating material above such a release layer, for instance by laser cutting or mechanical cutting. This allows for instance the formation of cavities which can be used in terms of component embedding and other applications.

In an embodiment, only a part of a main surface of the sheet is provided with the nano- and/or microstructures, whereas another part of the main surface of the sheet is free of the nano- and/or microstructures. By patterning a continuous layer of nano- and/or microstructures or by selectively depositing, growing or forming nano- and/or microstructures only in specific surface portions of a sheet, the functionalized surface of a sheet can be precisely defined. In some embodiments, it is desired that one or more portions of a sheet have dry adhesive properties and/or repellent properties, whereas one or more other portions of the sheet should be free of nano- and/or microstructures. This provides a further degree of freedom to a board designer for precisely defining the surface properties of such a sheet.

In an embodiment, the nano- and/or microstructures are exposed at an exterior surface of the component carrier. This may be advantageous for attachment to another body, when the nano- and/or microstructures are dry adhesive. This simplifies the surface mounting of a component on the component carrier. The component to be mounted may or may not be also provided with corresponding nano- and/or microstructures promoting adhesion. The described exposure may be also advantageous for defining a repellent surface portion (for instance when a dust free surface portion is desired).

In another embodiment, the nano- and/or microstructures are embedded in an interior of the component carrier. Thus, in such an embodiment, the nano- and/or microstructures with adhesive properties may be used for fixing a component to be embedded in an interior of the component carrier. Such a fixation may be a temporary or a permanent fixation. It may be, optionally, combined with a subsequent permanent connection by lamination.

In an embodiment, the component carrier comprises a component which is surface mounted on and/or embedded within the stack. The at least one component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration. The component may be surface mounted on the component carrier and/or may be embedded in an interior thereof.

In an embodiment, the sheet with the nano- and/or microstructures is arranged to contribute to a connection between the component and the stack. In one embodiment, the nano- and/or microstructures alone provide the connection force with the component. In another embodiment, the connection force may be a combined force provided by the nano- and/or microstructures on the one hand and a lamination force on the other hand. It is also possible that cooperating nano- and/or microstructures are formed on both connected surfaces of the component and the component carrier, for instance to establish an interconnection by interlocking between the opposing nano- and/or microstructures.

In an embodiment, the sheet with nano- and/or microstructures is a continuous layer or is a patterned layer. Therefore, the entire surface or only part of a surface of the sheet may have the specific adhesive or repellent property provided by the nano- and/or microstructures.

In an embodiment, the sheet with nano- and/or microstructures covers one of a planar surface and a three-dimensionally curved surface of the stack. Just as an example, such nano- and/or microstructures may be provided at a planar rigid board. However, three-dimensionally curved surfaces of flex boards or component carriers formed by three-dimensional printing may also be defined by a sheet with nano- and/or microstructures. The sheet may be rigid, flexible or bendable.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC su bstrate) .

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type component carrier. In such an embodiment, the component carrier is a compound of multiple layer structures which are stacked and connected together by applying a pressing force, if desired accompanied by heat.

In an embodiment, the body is surface-mounted on the component carrier by the sheet with nano- and/or microstructures. Therefore, the nano- and/or microstructures on the sheet surface may define a mounting position of a component to be mounted thereon by surface mounting.

In another embodiment, the body is embedded within the component carrier and is connected there by the sheet with nano- and/or microstructures. Therefore, the sheet with nano- and/or microstructures may contribute to the fixation of a component to be embedded in an interior of the component carrier.

In an embodiment, the stack has a through-hole for accommodating a component. The sheet may be connected to the stack as temporary carrier (or part thereof, wherein another part of such a temporary carrier may be a rigid plate or a flexible foil connected to the sheet) for delimiting a cavity, together with the through hole, for accommodating the component. In particular, the method may further comprise interconnecting at least one further electrically insulating layer structure and/or at least one further electrically conductive layer structure with the stack and the component in the cavity, and subsequently removing the temporary carrier from the stack and the component. This simplifies handling of the component and auxiliary structures during the embedding procedure. A sheet with nano- and/or microstructures as at least part of a temporary carrier may also be reused or recycled.

In an embodiment, the sheet with nano- and/or microstructures is arranged at an exterior surface of the component carrier, and a component is attached onto the sheet with nano- and/or microstructures. Thus, the sheet with nano- and/or microstructures may be used for surface mounting components on a component carrier or a pre-form thereof. Additionally or alternatively, the component to be mounted may be provided with a sheet of nano- and/or microstructures.

In another embodiment, the sheet with nano- and/or microstructures is arranged on top of an electrically conductive foil as temporary carrier structure beneath a recessed dielectric structure for accommodating a component. A conductive foil with a sheet with nano- and/or microstructures thereon can form a cheap and reusable temporary carrier to be used once or multiple times for supporting components and defining cavities in terms of component embedding.

The aspects defined above and further aspects of the invention are apparent from the examples of embodiment to be described hereinafter and are explained with reference to these examples of embodiment.
Figure 1 illustrates a cross-sectional view of a preform of a component carrier being presently under manufacture according to an exemplary embodiment of the invention.
Figure 2 illustrates a cross-sectional view of a preform of a component carrier being presently under manufacture according to another exemplary embodiment of the invention.
Figure 3 illustrates a cross-sectional view of a preform of a component carrier being presently under manufacture according to still another exemplary embodiment of the invention.
Figure 4 illustrates a three-dimensional view of a sheet with nano- and/or microstructures which may be used according to an exemplary embodiment of the invention for manufacturing a component carrier.
Figure 5 illustrates a cross-sectional view of an arrangement of two component carriers with cooperating sheets having interacting mushroom-shaped nano- and/or microstructures according to still another exemplary embodiment of the invention.
Figure 6 illustrates a cross-sectional view of a sheet being only partially covered with nano- and/or microstructures for use for a component carrier.
Figure 7 illustrates a cross-sectional view of a component carrier according to still another exemplary embodiment of the invention having exposed a sheet with nano- and/or microstructures for surface mounting a component.
Figure 8 illustrates a cross-sectional view of a component carrier according to yet another exemplary embodiment of the invention having embedded a sheet with repellent nano- and/or microstructures as release layer for forming a cavity for embedding a component.
Figure 9 illustrates a cross-sectional view of an arrangement of two component carriers with cooperating sheets with interacting nano- and/or microstructures for forming a board-in-board device according to still another exemplary embodiment of the invention.
Figure 10 illustrates a cross-sectional view of an arrangement of two component carriers with cooperating sheets with interacting nano- and/or microstructures of hook and loop type according to still another exemplary embodiment of the invention.
Figure 11 illustrates a cross-sectional view of a sheet according to an exemplary embodiment of the invention being covered with T-shaped nano- and/or microstructures for a component carrier.
Figure 12 illustrates a cross-sectional view of a sheet according to an exemplary embodiment of the invention being covered with ball-shaped nano- and/or microstructures for a component carrier.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment, a nano-coated structure may be used for component carrier technology, in particular as a dry-adhesive structure. An adhesive layer implementing such a surface configuration may also be denoted as gecko film. The adhesive effect of such a surface may be based on van der Waals forces. Descriptively speaking, a plurality of low dimensioned suction cups may be formed by such a concept. According to an exemplary embodiment of the invention, a reliable substrate and/or structured material is provided for embedding and/or surface mounting applications having specific adhesion properties due to a corresponding configuration of nano- and/or microstructures on this surface. Exemplary embodiments have the advantage that the mentioned adjustability of the surface adhesion properties may be obtained with low material consumption, low production costs, small contamination risk, and high process reliability.

In an embodiment, the mentioned materials may be used as support for component placement in embedding technologies. Compared to a traditional adhesive tape system that is depending on temperature and time, an exemplary embodiment uses the surface of a support (which may be rigid or flexible) or a PCB elements (such as cores, prepregs, copper foils, etc.), that exhibits, thanks to the nano- and/or microstructures, van der Waals attraction forces, a gecko effect, a high grip, and that is dry and thus can be cleaned and reused. A sheet with nano- and/or microstructures can also be included in the final product. When used for an embedding concept, components may be placed on the dry surface and can be held in position by weak bonds (like van der Waals forces, gecko effect, high grip values) prior to the component lamination.

Such an architecture allows to obtain a dry interaction between the component and the holding substrate. No additional liquid adhesive is required. This has the advantages of a dry interaction, and a reduction of risk of contamination from the substrate.

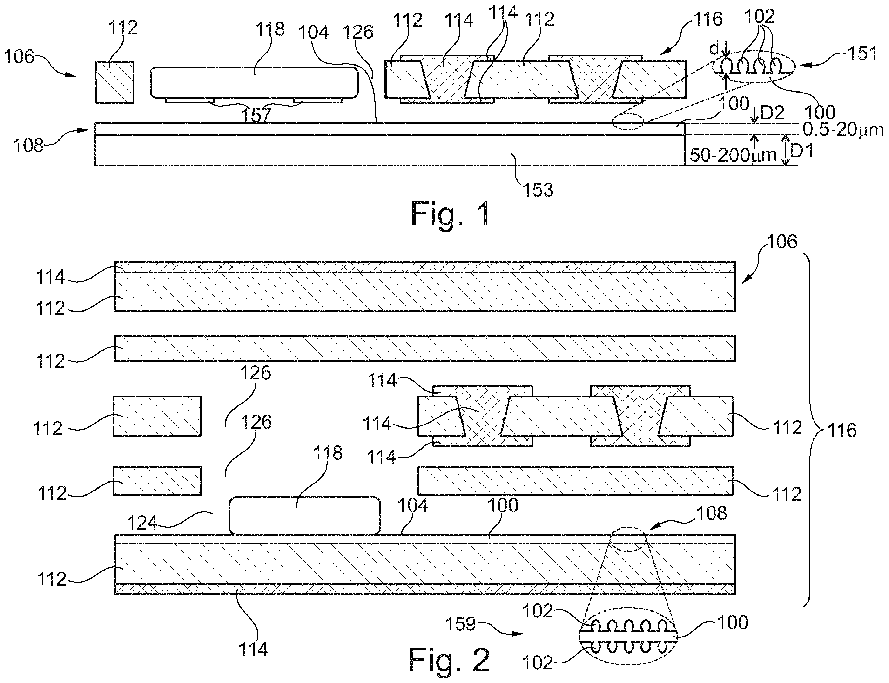

**Figure 1** illustrates a cross-sectional view of a preform of a component carrier 106 being presently under manufacture according to an exemplary embodiment of the invention.

The component carrier 106 under manufacture comprises an interconnected stack 116 comprising electrically conductive layer structures 114 (in the shown embodiment patterned copper layers and vertical interconnect structures embodied as copper vias) and an electrically insulating layer structure 112 (here embodied as core of fully cored resin with reinforcing fibers therein, in particular FR4). The stack 116 has been interconnected by lamination. The stack 116 is provided with a through hole 126 into which an electronic component 118 (in the shown embodiment a semiconductor chip having pads 157) can be inserted during a procedure of embedding the electronic component 118 within the component carrier 106.

A sheet 100, which is here embodied as a continuous planar layer, is provided with a large number of matrix-like arranged nano- and/or microstructures 102 (see detail 151) on an exposed surface thereof and is here mounted on a rigid carrier plate 153. There are various methods of manufacturing the nano- and/or microstructures 102 on a surface of the sheet 100. In one embodiment, the nano- and/or microstructures 102 may be grown on the surface of the sheet 100 (for instance as carbon nanotubes). In another embodiment, the nano- and/or microstructures 102 may be formed by exposing the sheet surface 104 to a laser treatment. It is also possible to form the nano- and/or microstructures 102 by depositing material on the surface of the sheet 100. Together, the sheet 100 and the carrier plate 153 form a temporary carrier which does not form part of the readily manufactured component carrier 106, but is only used temporarily during the embedding procedure. Since the sheet 100 with the nano- and/or microstructures 102 acts as a dry adhesive (see reference numeral 108, similar as a skin of a gecko), the sheet 100 will be self-adhesive without the need to apply an additional (in particular liquid) adhesive material thereon.

For embedding, the sheet 100 on the carrier plate 153 is interconnected with the stack 116 due to a dry adhering configuration of the nano- and/or microstructures 102. If desired, this temporary interconnection may be reinforced by lamination, i.e. the application of temperature and/or pressure. However, also the pronounced van der Waals forces alone which are exerted between the nano- and/or microstructures 102 and a counter surface may be sufficient for establishing a reliable temporary connection. Thereafter, the electronic component 118 is inserted into the now closed through hole 126 in the stack 116 and is temporarily adhered to the sheet 100 by action of the nano- and/or microstructures 102. Thus, the sheet 100 with the nano- and/or microstructures 102 is arranged to contribute to a connection between the component 118 and the stack 116.

Although not shown in Figure 1, the so obtained structure may then be laminated with further electrically conductive layer structures (such as copper foils) and/or with further electrically insulating layer structures (such as prepreg sheets) on the top side of stack 106. After that, the temporary carrier may be removed from the rest of the structure, which is now sufficiently rigid. If desired, and although not shown in Figure 1, the so obtained structure may then be laminated with further electrically conductive layer structures (such as copper foils) and/or with further electrically insulating layer structures (such as prepreg sheets) on the top side and/or on the bottom side.

As a result, a component carrier 106 shaped as a plate may be obtained and being configured as a printed circuit board (PCB) with embedded electronic component 118. Figure 1 and the above description hence relate to a method of manufacturing the component carrier 106, in which the stack 116 with its through-hole 126 is used for accommodating the electronic component 118. The sheet 100 is connected together with the carrier plate 153 only temporarily to the stack 116 as temporary carrier for delimiting a cavity. According to Figure 1, the sheet 100 with its nano- and/or microstructures 102 on exposed sheet surface 104 is used during the procedure of manufacturing component carrier 106, while the sheet 100 with its nano- and/or microstructures 102 does not form part of the readily manufactured component carrier 106, but is removed therefrom. The sheet 100 is used as temporary dry adhesive 108 which may be provisionally connected to both the stack 116 and the electronic component 118 until they are connected in such a rigid way that the temporary carrier is no longer needed for providing support.

In the shown embodiment, the sheet 100 with its nano- and/or microstructures 102 may be made of an electrically insulating material such as prepreg or FR4. When the sheet 100 is made of an already cured material, this material will not re-melt and be cured (in particular by cross-linking) during lamination on the bottom surface of the stack 116 and of the electronic component 118. As a result, the sheet 100 which already provides an adhesive function due to its nano- and/or microstructures 102, can be removed easily from the stack 116 and the electronic component 118 after having laminated material on top of stack 116 and the electronic component 118.

As can be taken from Figure 1, a thickness D1 of the (in particular rigid) carrier plate 153 can be in a range between 50 µm and 200 µm. A thickness D2 of the sheet 100 may be in a range between 0.5 µm 20 µm. A height d of the nano- and/or microstructures 102 may be in a range between 0.1 nm and 10 µm, preferably in a range between 1 nm and 100 nm.

Figure 1 therefore shows how sheet 100 with nano- and/or microstructures 102 on sheet surface 104 is fixed temporarily on carrier plate 153. Carrier plate 153 may for example be a metal plate, a ceramic plate or a core of FR4 material. In the shown embodiment, the sheet 100 with the nano- and/or microstructures 102 has dry adhesive properties on its exposed surface so that the core composed of the electrically insulating layer structure 112 and the electrically conductive layer structures 114 may be fixed on the sheet 100 by simply attaching the sheet to the stack 116 or core. Moreover, also the component 118 to be embedded may be fixed on the dry adhesive surface of the sheet 100 when being placed in the cavity formed by the through hole 126 and the temporary carrier closing a bottom of the through hole 126. Thus, the embodiment of Figure 1 shows embedding with a dry adhesive nano coating.

**Figure 2** illustrates a cross-sectional view of a preform of a component carrier 106 being presently under manufacture according to another exemplary embodiment of the invention.

In contrast to Figure 1, Figure 2 illustrates a scenario in which a sheet 100 with nano- and/or microstructures 102 on sheet surface 104 is used as a permanent carrier having surface adhesive properties for dry adhesion with a component 118 to be embedded. An electrically insulating layer structure 112 (for instance a prepreg layer) is arranged on top of an electrically conductive layer structure 114 (here embodied as a continuous copper foil) and is covered with the sheet 100. Both opposing main surfaces of the sheet 100 may be covered with nano- and/or microstructures 102 (compare detail 159) so as to promote adhesion between the electrically insulating layer structure 112 and the sheet 100, and to promote also adhesion between the sheet 100 and a component 118 (for instance a copper block for dissipating heat) to be embedded in the component carrier 106 under manufacture. Thus, the nano- and/or microstructures 102 of the sheet 100 serve as dry adhesive and ensure that the component 118 remains in place during the embedding procedure, and without the need of adding liquid adhesive. Further electrically insulating layer structures 112 and electrically conductive layer structures 114 form a structure having through holes 126 and may be placed on the previously described arrangement of elements 118, 100, 112, 114. The component 118 is therefore accommodated in the through holes 126. Further additionally, two continuous electrically insulating layer structures 112 (for instance continuous prepreg foils) and a further electrically conductive layer structure 114 (for instance a continuous copper foil) are placed on top of the previously mentioned arrangement. The mentioned elements may then be interconnected by lamination, i.e. the application of heat and/or pressure (not shown). During this lamination, at least partially uncured material of part or all of the electrically insulating layer structures 112 and optionally also at least partially uncured material of the sheet 100 may re-melt, may undergo cross-linking and may then be re-solidified. The result of the described procedure is a component carrier 106 according to an exemplary embodiment of the invention.

According to Figure 2 (and in contrast to Figure 1), the sheet 100 with the nano- and/or microstructures 102 remains part of the readily manufactured component carrier 106. Advantageously, it may be made of the same material as the other constituents of the component carrier 106 under manufacture, for instance prepreg. More generally, the sheet 100 with the nano- and/or microstructures 102 may be made of resin (such as an epoxy resin) with reinforcing particles (in particular fibers, more particularly glass fibers). A first advantage of such a configuration is that the material of the sheet 100 may be at least partially uncured and may be cured during the lamination procedure so as to contribute to the connection force between the constituents of the component carrier 106. A second advantage of this configuration is that the material of the sheet 100 has very similar material properties as other elements of the component carrier 106 which keeps thermal load (for instance due to different coefficients of thermal expansion within the component carrier 106) small. It should be said that the second advantage can also be achieved when the sheet 100 is made of an electrically conductive material as used in PCB technology, in particular copper. In the latter mentioned embodiment, the nano- and/or microstructures may also be nanowires, in particular copper nanowires.

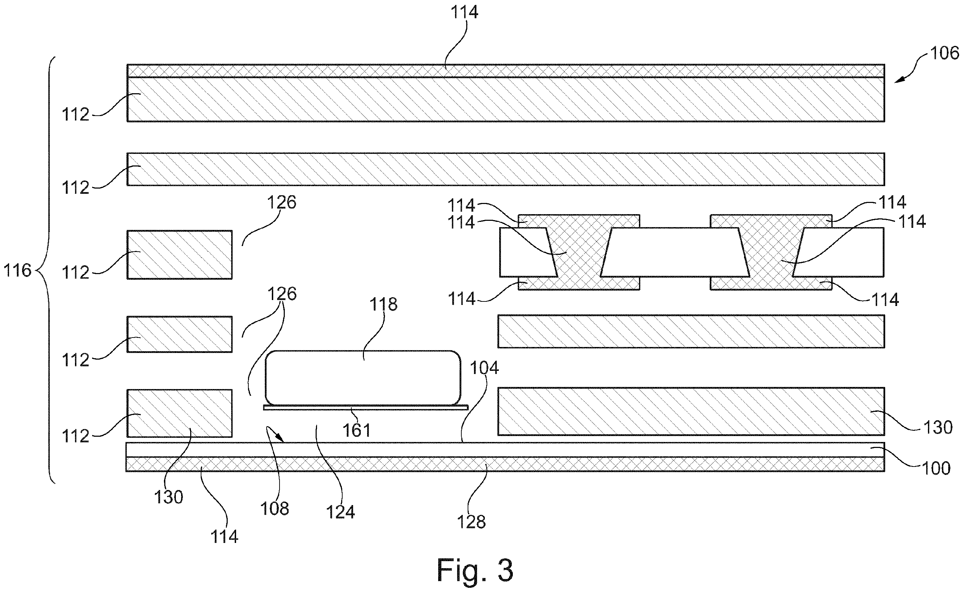

**Figure 3** illustrates a cross-sectional view of a preform of a component carrier 106 being presently under manufacture according to still another exemplary embodiment of the invention.

According to Figure 3, a sheet 100 with nano- and/or microstructures 102 is arranged on top of an electrically conductive foil 128 serving now, together with sheet 100, as flexible temporary carrier structure (rather than forming part of a readily manufactured component carrier 106) beneath a recessed dielectric structure 130 for accommodating a component 118. A through hole 126 of the recessed dielectric structure 130 together with the continuous double layer composed of the electrically conductive foil 128 and the sheet 100 form or delimit a cavity 124 in which the component 118 is embedded. Further layer structures 112, 114 are arranged above the mentioned elements, in a similar way as shown in Figure 2. After the elements shown in Figure 3 have been interconnected by lamination, the flexible temporary carrier structure (see reference numerals 128, 100) may be removed from the manufactured component carrier 106. If desired, the flexible temporary carrier structure may be re-used.

It should furthermore be mentioned that, according to Figure 3, a bottom surface of the component 118 may be provided with an optional auxiliary layer 161. The auxiliary layer 161 may be a layer of (for instance liquid or viscous) adhesive or may be a further sheet 100 with nano- and/or microstructures 102. Hence, the auxiliary layer 161 may contribute to a reliable connection with sheet 100 of the temporary carrier structure beneath.

The embodiment of Figure 3 differs from the embodiment of Figure 1 and Figure 2 in that the sheet 100 is now connected on flexible or bendable electrically conductive foil 128, more precisely a copper foil, as electrically conductive layer structure 114 connected to a lower surface of the sheet 100.

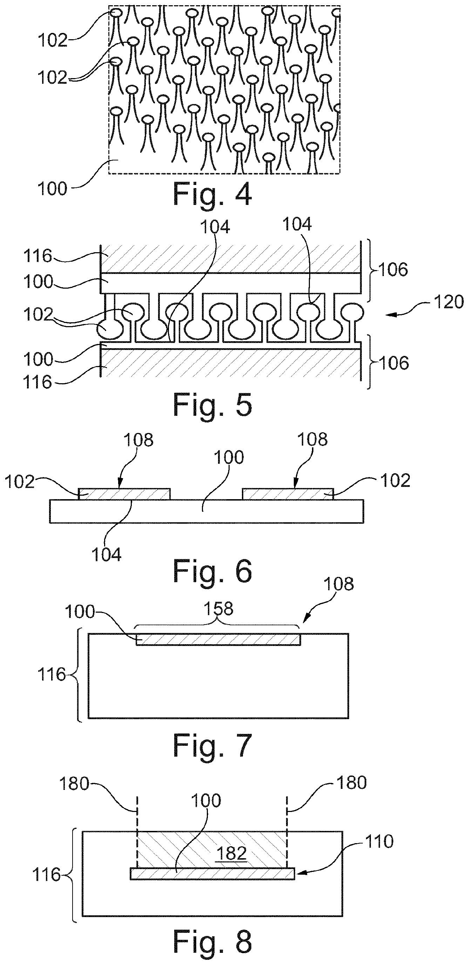

**Figure 4** illustrates a three-dimensional view of a sheet 100 with nano- and/or microstructures 102 for a component carrier 106. More precisely, Figure 4 shows a microscopic image of a sheet 100 with a regular array of mushroom-shaped nano- and/or microstructures 102 thereon.

**Figure 5** illustrates a cross-sectional view of an arrangement 120 of two component carriers 106 with cooperating sheets 100 with interacting mushroom-shaped nano- and/or microstructures 102 according to still another exemplary embodiment of the invention.

Although not shown in detail in Figure 5, each of the component carriers 106 may comprises a respective stack 116 comprising at least one electrically conductive layer structure 114 and/or at least one electrically insulating layer structure 112, for instance in the manner as shown in Figure 1 to Figure 3. The two cooperating sheets 100 of Figure 1 are arranged so that their sheet surfaces 104 with the mushroom-shaped nano- and/or microstructures 102 are brought in interaction, i.e. in interlocking interaction. Thus, the sheets 100 of the component carriers 106 are used for establishing a detachable connection between the component carriers 106. The component carriers 106 may be simply plugged together or pulled away from one another. In other words, the two component carriers 106 may be connected and disconnected multiple times. This temporary or reversible connection can be established by interlocking between the nano- and/or microstructures 102 of one of the sheets 100 and the nano- and/or microstructures 102 of the other sheet 100.

When the sheets 100 with nano- and/or microstructures 102 are completely or partially electrically conductive, for instance made of copper, the connection and disconnection between the sheets 100 of the component carriers 106 may establish or disable an electric connection and therefore a common electronic functionality between the component carriers 106.

Figure 5 thus shows how two corresponding sheets 100 with the same type of nano- and/or microstructures 102 on connection surfaces thereof are interconnected in a similar way as in case of a Velcro fastener for providing a reversible connection between the sheets 100 and consequently between their assigned component carriers 106.

In another advantageous embodiment, the principle described referring to Figure 5 may also be used for connecting two constituents of a component carrier 106 during its manufacture. For instance, two electrically insulating layer structures 112 (for instance prepreg foils), two electrically conductive layer structures 114 (for instance copper foils), or one electrically insulating layer structure 112 (for instance a prepreg foil) and one electrically conductive layer structure 114 (for instance a copper foil) may be connected without glue merely by connecting two cooperating sheets 100 with nano- and/or microstructures 102.

**Figure 6** illustrates a cross-sectional view of a sheet 100 being only partially covered with nano- and/or microstructures 102 for a component carrier 106.

Thus, it is possible that only a part of a main surface of the sheet 100 is provided with the nano- and/or microstructures 102, whereas another part of the main surface of the sheet 100 is free of the nano- and/or microstructures 102. As a result, a sheet 100 may be obtained in which one partial surface has a dry adhesive property, whereas another partial surface may be non-adhesive. Therefore, for example by patterning procedures (such as a lithography and etching procedure), the specific surface properties of a sheet 100 can be precisely adjusted with low effort. In a similar way, it is also possible that only a part of a surface of the sheet 100 can be equipped with nano- and/or microstructures 102 having a repellent effect (for instance to ensure a dust-free or water-free surface region).

**Figure 7** illustrates a cross-sectional view of a component carrier 106 according to still another exemplary embodiment of the invention having an exterior exposed sheet 100 with nano- and/or microstructures 102 for surface mounting a component 118 (not shown, but for instance embodied as shown in Figure 1, Figure 2 or Figure 3). According to Figure 7, the sheet 100 with nano- and/or microstructures 102 is arranged at an exterior surface of the component carrier 106, and the component 118 is attached onto the sheet 100 with nano- and/or microstructures 102 (in particular without other material, such as solder material, between the component 118 and the sheet 100 with nano- and/or microstructures 102). Figure 7 hence shows that a mounting surface 158 of the component carrier 106 may be equipped with a sheet 100 with nano- and/or microstructures 102 so as to allow a component 118 (which may also be equipped with a sheet 100 with nano- and/or microstructures 102, not shown in Figure 7) to be (in particular detachably) surface-mounted on the component carrier 106 with low effort. Advantageously, an electric connection between component carrier 106 and component 118 can be established upon mounting the component 118 on the nano- and/or microstructures 102, without the need to take any further measure.

**Figure 8** illustrates a cross-sectional view of a component carrier 106 according to yet another exemplary embodiment of the invention having embedded a sheet 100 with repellent nano- and/or microstructures 102 (for instance as a result of a coating of the nano- and/or microstructures 102 with a material such as a wax or polytetrafluoroethylene (PTFE)) as release layer for forming a cavity 124 needed for embedding a component 118.

Thus, contrary to the embodiments of Figure 1 to Figure 7, the microstructures 102 of the sheet 100 according to Figure 8 are configured to be repellent (for instance with a configuration similar to that of a surface of a lotus flower) rather than adhesive. As a result, the sheet 100 is releasable from a stack 116 composed of electrically conductive layer structures 114 and/or electrically insulating layer structures 112 due to a repellent configuration of the nano- and/or microstructures 102.

As can be taken from Figure 8, the nano- and/or microstructures 102 are embedded in an interior of the component carrier 106. In this embodiment, the sheet 100 is used as repellent structure 110 or as a release layer. When the structure shown in Figure 8 is made subject to a laser treatment (see laser cutting lines 180), a material block indicated with reference numeral 182 and defined by the laser cutting lines 180 in combination with the position of the sheet 100 can be simply removed from the rest of the shown preform of a component carrier 106. For instance, a component 118 can then be embedded in the so manufactured cavity 124.

Therefore, Figure 8 shows a corresponding situation as in Figure 7, however with two significant differences. On the one hand, the sheet 100 with the nano- and/or microstructures 102 is now embedded in an interior of the component carrier 106. On the other hand, as indicated by reference numeral 180, upon cutting along the there shown lines, the material block 182 of the component carrier 106 may be removed therefrom, since in the shown embodiment, the sheet 100 with nano- and/or microstructures 102 has repellent or non-adhesive properties. Therefore, it here serves as a release layer. The material block 182 may be therefore simply removed from the remainder of the component carrier 106 for the formation of cavity 124. This can be for instance advantageous in terms of forming cavities 124 for subsequently embedding components 118.

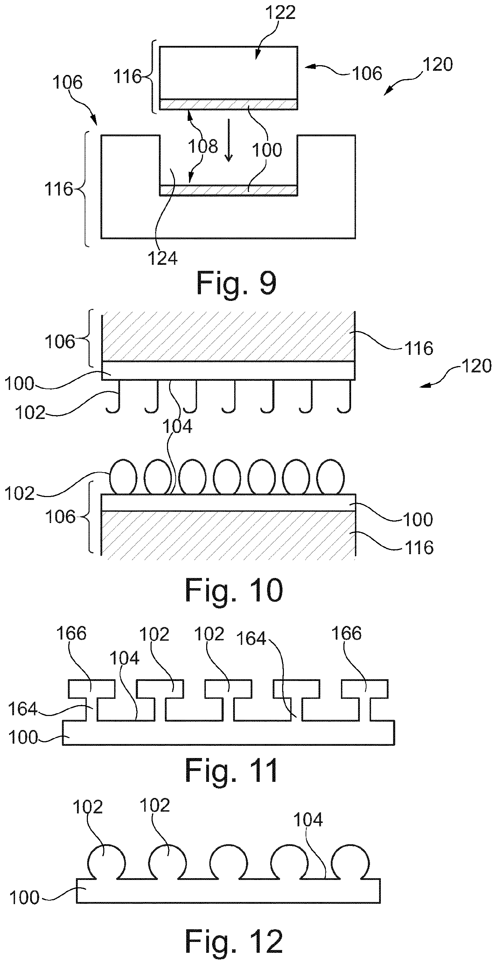

**Figure 9** illustrates a cross-sectional view of an arrangement 120 of two component carriers 106 (such as two printed circuit boards (PCB)) with cooperating sheets 100 with interacting nano- and/or microstructures 102 for forming a board-in-board device according to still another exemplary embodiment of the invention.

Thus, each of the component carrier 106 with the cavity 124 (which may be manufactured as described referring to Figure 8) and the body 122, which may be a further component carrier 106, comprises a respective sheet 100 with nano- and/or microstructures 102 configured as a dry adhesive 108 for holding the component carrier 106 and the further body 122 on one another. Hence, cooperating (for instance interlocking) nano- and/or microstructures 102 may be exposed at an exterior surface of both the component carrier 106 and on the other body 122. In the shown embodiment, the body 122 is embedded within the component carrier 106 and is connected there by the sheets 100 with nano- and/or microstructures 102.

**Figure 10** illustrates a cross-sectional view of an arrangement 120 of two component carriers 106, embodied as printed circuit boards, with cooperating sheets 100 with interacting nano- and/or microstructures 102 of hook and loop type according to still another exemplary embodiment of the invention.

Figure 10 shows an exemplary embodiment, in which two cooperating sheets 100 are connected with one another in a Velcro type, however implemented in terms of component carrier manufacture or handling. As can be taken from Figure 10, the lower sheet 100 has microstructures 102 of a loop type, whereas the upper sheet 100 in Figure 10 has microstructures of a hook type. The hooks and the loops may interconnect with one another for the formation of a for instance reversible interconnection between the two portions of the component carrier 106 embodied by the two sheets 100 as shown in Figure 10.

**Figure 11** illustrates a cross-sectional view of a sheet 100 being covered with T-shaped nano- and/or microstructures 102 for a component carrier 106. In other words, Figure 11 shows that the nano- and/or microstructures 102 may also be posts 164 with laterally widened hats 166.

**Figure 12** illustrates a cross-sectional view of a sheet 100 being covered with ball-shaped nano- and/or microstructures 102 for a component carrier 106. Therefore, Figure 12 shows that the nano- and/or microstructures 102 may also be ball-like structures.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A component carrier (106), wherein the component carrier (106) comprises:
a stack (116) comprising at least one electrically conductive layer structure (114) and/or at least one electrically insulating layer structure (112);
a sheet (100) with nano- and/or microstructures (102) and arranged on and/or in the stack (116), said sheet (100) comprising or consisting of copper.

2. The component carrier (106) according to claim 1, wherein the sheet (100) is interconnected with the stack (116) by a dry adhering configuration of the nano- and/or microstructures (102),

3. The component carrier (106) according to claim 2 wherein the sheet (100) is laminated on or within the stack (116).

4. The component carrier (106) according to any of claims 1 to 3, wherein only a part of a main surface of the sheet (100) is provided with the nano- and/or microstructures (102), whereas another part of the main surface of the sheet (100) is free of the nano- and/or microstructures (102).

5. The component carrier (106) according to any of claims 1 to 4, wherein the nano- and/or microstructures (102) are exposed at an exterior surface of the component carrier (106), in particular for attachment to another body (122), more particularly for a detachable attachment to another body (122).

6. The component carrier (106) according to any of claims 1 to 5, wherein the nano- and/or microstructures (102) are embedded in an interior of the component carrier (106).

7. The component carrier (106) according to any of claims 1 to 6, comprising a component (118) which is surface mounted on and/or embedded within the stack (116).

8. The component carrier (106) according to claim 7, wherein the sheet (100) with the nano- and/or microstructures (102) is arranged to contribute to a connection between the component (118) and the stack (116).

9. The component carrier (106) according to any of claims 1 to 8, wherein the sheet (100) with nano- and/or microstructures (102) is a continuous layer or a patterned layer.

10. The component carrier (106) according to any of claims 1 to 9, wherein the sheet (100) with nano- and/or microstructures (102) covers one of a planar surface and a three-dimensionally curved surface of the stack (116).

11. The component carrier (106) according to any of claims 1 to 9, wherein the nano- and/or microstructures (102) comprise nanowires.

12. The component carrier (106) according to claim 11, wherein the nanowires are copper nanowires.

13. An arrangement (120), wherein the arrangement (120) comprises:
a component carrier (106) comprising a stack (116) with at least one electrically conductive layer structure (114) and/or at least one electrically insulating layer structure (112);
a body (122);
wherein at least one of the component carrier (106) and the body (122) comprises a sheet (100) with nano- and/or microstructures (102) configured as a dry adhesive (108) for connecting, in particular detachably connecting, the component carrier (106) and the further body (122), said sheet (100) comprising or consisting of copper.

14. The arrangement (120) according to claim 13, wherein the body (122) is surface-mounted on the component carrier (106) by the sheet (100) with nano- and/or microstructures (102);

15. The arrangement (120) according to claim 13, wherein the body (122) is inserted in or embedded within the component carrier (106) and is connected with the component carrier (106) by the sheet (100) with nano- and/or microstructures (102).
